# EUROPEAN PATENT APPLICATION

(11) **EP 1 732 126 A1**
(43) Date of publication of application: **13.12.2006**
(21) Application number: 05447133.9
(22) Date of filing: 08.06.2005
(51) Int. Cl.: H01L 21/98, H01L 21/60, H01L 21/56, H01L 23/498

(54) **Method for bonding and device manufactured according to such method**

(71) Applicant: INTERUNIVERSITAIR MICROELEKTRONICA CENTRUM ( IMEC), 3001 Leuven (BE)
(72) Inventor: Beyne, Eric, 3001 Leuven (BE)
(74) Representative: Van Malderen, Joëlle

(57) **Abstract**

The present invention is related to a method for bonding comprising the steps of
producing on a first main surface of a first element a first solder ball,
producing on a first main surface of a second element a second solder ball,
providing contact between the first solder ball and the second solder ball,
bonding the first element and the second element by applying a reflow step whereby the solder balls melt and form a joined solder ball structure
wherein, prior to the bonding step, the first solder ball is laterally embedded in a non conductive material, such that the upper part of the first solder ball is not covered by the non-conductive material. It related also to devices according to such methods.

## Description

### Field of the invention

The present invention relates to the field of microelectronics. It relates to methods for bonding 2 elements, as for instance the bonding of 2 wafers, wafer and dies or dies and dies, particularly in the field of 3D-SIP (3-dimensional System in a Package) technologies.

### Background of the invention

In the field of 3D stacking of system-in-Package (SIP) devices, packages are used with solder ball connections (BGA; Ball Grid Array) and CSP (Chip Scale Package) -style connections. Also in other fields solder balls can be used to provide bonding between 2 elements.

In order to realize a dense 3D interconnection between such devices, small diameter solder-balls are required. However the diameter has to be larger than the height of the components, which are typically present on the individual SIP layers or elements.

### Aim of the invention

It is an aim of this invention to provide a method and corresponding devices for bonding 2 elements, as for instance the bonding of two SIP layers which can be part of a 3D-stack or multilayer stack, which alleviates or avoids the problems of the prior art.

### Summary of the invention

According to embodiments of the present invention, the solder balls of a first substrate are encapsulated in a polymer resin (e.g. glob-top epoxy or packaging plastic molding compound) and only exposed at the top surface. The solder ball of the second substrate can then be mounted on the first ball, without the risk of collapse of the solder column or shorting between neighbouring solder connections.

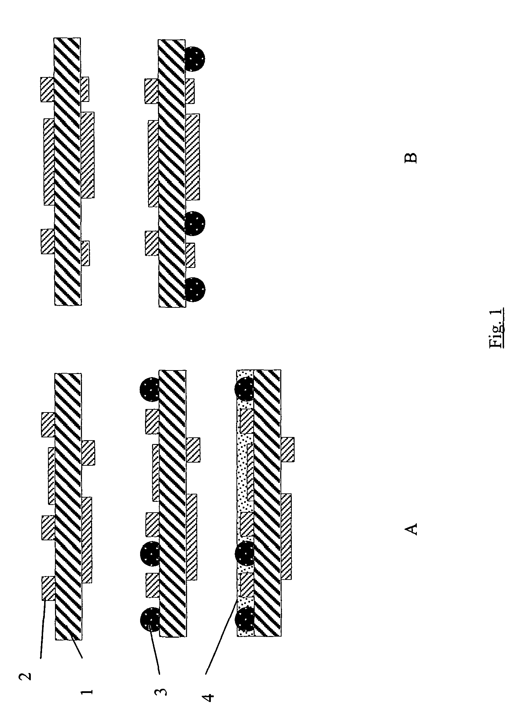

For the purpose of the present invention, SiP packages should be understood as packages comprising an interconnect substrate 1 and devices 2 mounted on its surface (see Fig. 1). The thus packaged circuit can realize a system or subsystem functionality. Components can be mounted on both sides of the CSP substrates. These devices can be wire-bonded or flip-chip mounted IC's, standard SMD passives or other components such as clock reference crystals, but also other devices. These components can typically be characterised by having a height above the substrate different from zero and up to several hundreds of micrometer.

The solder balls can have a diameter between 100 microns and 1 mm.They can for instance have a diameter of 200, 300, 400, 500, 600, 700, 800, 900 microns. Also smaller or larger solder balls are possible.

In a first aspect of the present invention, a method for bonding is disclosed comprising the steps of
- producing on a first main surface of a first element a first solder ball,
- producing on a first main surface of a second element a second solder ball,
- providing contact between the first solder ball and the second solder ball,
- bonding the first element and the second element by applying a reflow step whereby the solder balls melt and form a joined solder ball structure
wherein, prior to the bonding step, the first solder ball is laterally embedded in a non-conductive material (therefore called embedding layer), such that the upper part of the first solder ball is not covered by the non-conductive material.

In certain embodiments, the non-conductive material is laterally embedding the first solder ball up to an embedding level parallel to the first main surface and which does not extend above the first solder ball.

In certain embodiments, a step of applying a underfill/overmould material after the bonding step between the first main surface of the second element and the first main surface of the first element can be applied.

Also the second solder ball can be laterally embedded in a non-conductive material, such that the upper part of the second solder ball is not covered by the non-conductive material. This non-conductive material is preferably laterally embedding (therefore called embedding layer) the second solder ball up to an embedding level parallel to the first main surface and which does not extend above the second solder ball.

In advantageous embodiments the first main surface of the first element and/or the first main surface of the second element comprise components or structures, whereby the first and the second solder balls are such that the height of the components and/or structures is smaller then the height of the first solder ball and/or the second solder ball respectively. In such embodiment the height of the embedding layer(s) should preferably be higher then the height of the components (and of course lower then the respective solder ball height).

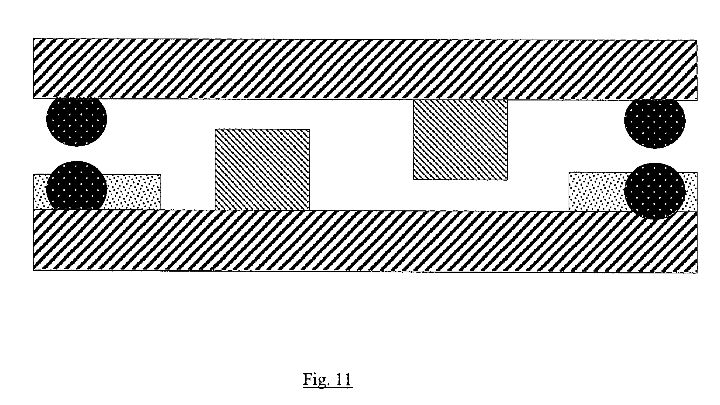

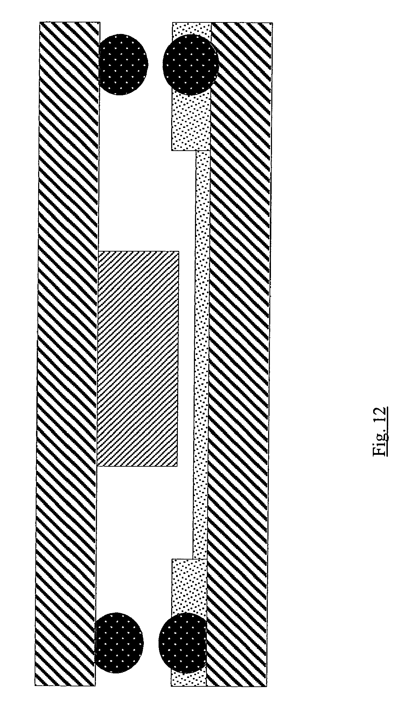

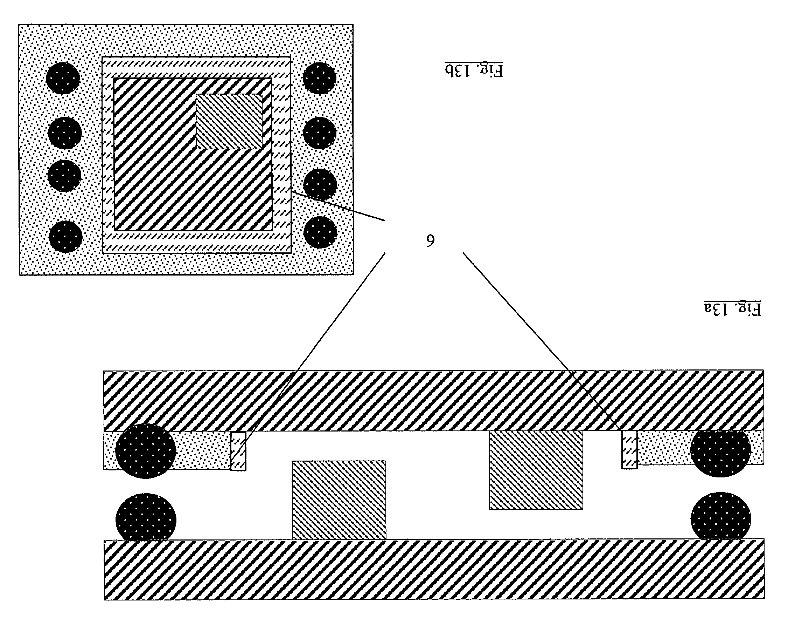

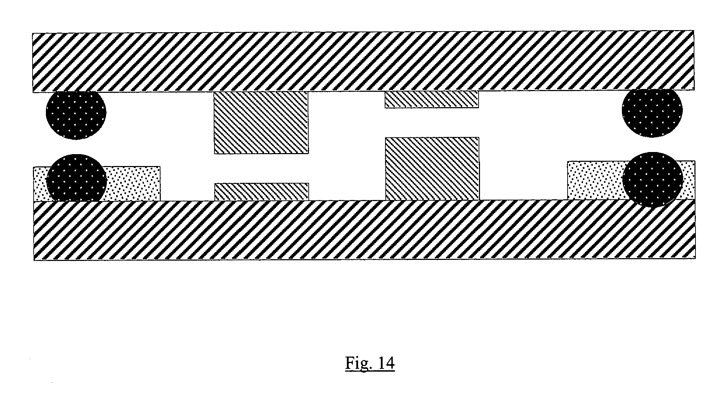

In certain embodiments the first main surface of the first element and/or the first main surface of the second element comprise components or structures which have a topology that extends outwards from the respective main surfaces, and whereby the first and the second solder balls are such that the height of at least one of the components and/or structures on the first main surface of the first element and/or the first main surface of the second element is smaller then the height of the joined solder ball structure, but higher than the solder balls on the corresponding main surface. These embodiments can be achieved by providing preformed embedding layers which for instance include exclusion areas (see eg Fig. 11, Fig 13a,b and Fig 14), or recesses (see eg Fig. 12), ie areas in which no or only a thinner layer of non conductive material is present respectively. Such embedding layers which comprise exclusion areas or recesses can be produced by transfer moulding or injection moulding techniques. Also a glob-top technique whereby a liquid encapsulant is applied can be used. The presence of additional confinement structures 6 (eg see Fig. 13), which provide enclosures corresponding to exclusion areas, may be necessary, such that no non-conductive solder ball embedding material can enter the exclusion area. Such confinement structures are not always necessary; moulding techniques can also be used which provide exclusion areas. In embodiments whereby exclusion areas are provided on both main surfaces (or similar whereby an embedding layer is only present on one main surface only and comprises an exclusion area), which moreover overlap, and in which on both main surfaces in the respective exclusion area, components are provided, special care should further be taken in the positioning of the components on the first main surfaces, such that components present on the first main surface of a first element are not blocked by components mounted on the first main surface of the second element when both elements are to be bound. This can be achieved by combining lower height components on a first main surface of a first element, with higher height components on a main surface of a second element (eg see Fig. 14), or by misaligning the components on the first and second main surfaces on the first and second elements respectively (see Fig. 11). The combined height of the two components should though be smaller then the joined solder ball structure. It should further be understood that lower and higher components in an exclusion area on a first main surface of a first element can be combined with higher and lower components respectively in an exclusion area on a second main surface of a second element. Such embodiments are shown in Fig. 14.

In preferred embodiments, a step of applying an underfill / overmold operation, which fills up the remaining gaps between the elements can be applied.

The embodiments of the methods according to ) the present invention can of course be used repetitively for stacking more then 2 or 3 elements.

A method for producing stacked structures is disclosed, wherein methods according to one of the earlier described embodiments is applied an integer number of times, by repetitively bonding a main surface of an element, bonded before by a method according to the present invention, to a main surface of a further element.

In an embodiment wherein more then 2 elements are stacked, the step of applying an underfill/overmold operation can advantageously be applied only once for the whole stacked structure, although this is not strictly necessary.

The elements referred to can be any element known to be usable to a person of ordinary skill in the art, but can for instance be substrates, wafers, chips or dies.

In a second aspect of the present invention devices are disclosed, corresponding to the first aspect of the invention, comprising at least 2 elements, the elements being bonded by a bonding structure located between a first main surface of a first element and a first main surface of a second element, wherein the bonding structure comprises a solder structure which is essentially a stack of a lower and an upper solder ball, which are forming a single structure.

In certain embodiments, the solder structure is essentially 8-shaped; which means that any cross-section of the structure along the lontitudinal axis provides a "8" form, the form of the number "eight". Each of the 2 loops of this 8-shape then corresponds to a solder ball.

In certain embodiments the lower or/and the upper solder ball(s) is/are laterally embedded in a non conductive material up to an embedding level which is lower then the height of the top surface of the respective solder balls.

In certain embodiments the first main surface of at least one of the elements comprises at least one component which extends outwards from the first main surface of the corresponding element, and the respective embedding levels are further such that the component(s) are completely covered by the non conductive material.

The bonding structure can further comprise a layer of underfill / overmold material in between the first main surfaces of the elements.

The invention is further related to a device, wherein the layer of underfill/overmould material is located between a first main surface of one element and an embedding layer on a first main surface of a second element or between the 2 embedding layers of the 2 first main surfaces of the 2 elements respectively.

### Description of the figures

The figures 1-9 represent methods and devices according to embodiments of the present invention. In Fig. 1 to Fig. 4 embodiments wherein 2 elements are bonded are illustrated.

Fig. 1: preparation of the SiP substrate (case of 2 substrates).

Fig. 2: principle of the SiP substrate stacking (case of 2 substrates).

Fig. 3a: principle of the SiP substrate stacking : using wafer or substrate as a basis. (case of 2 substrates).

Fig. 3b: principle of the SiP substrate stacking: using wafer or substrateas a basis. (case of 2 substrates).

Fig. 4: principle of the SiP substrate stacking : including bottom-side molding (case of 2 substrates).

In Fig. 5 and Fig. 6 embodiments wherein 3 or more elements or substrates are bonded are illustrated.

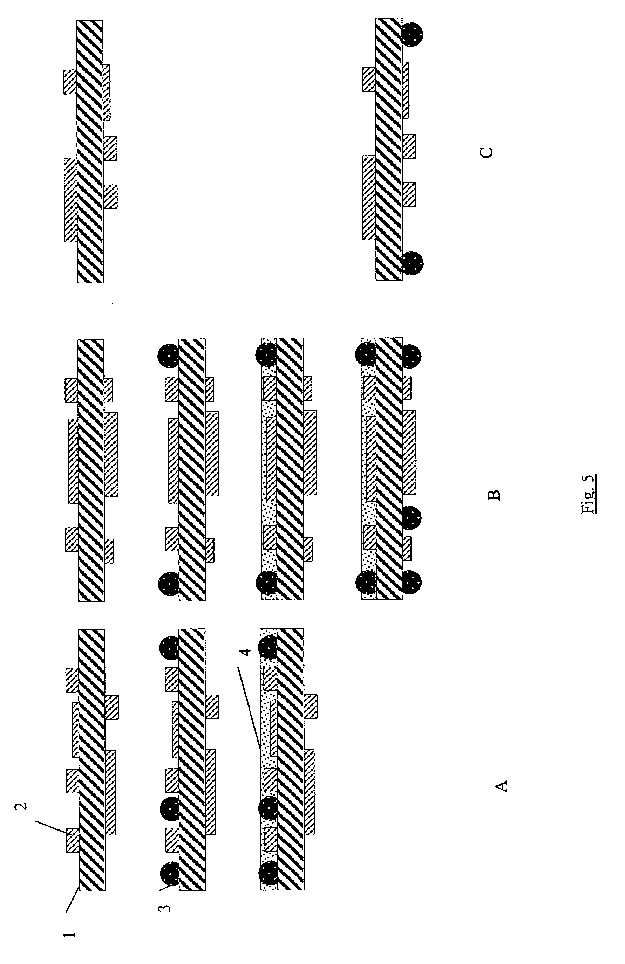

Fig. 5: preparation of the SiP substrate (case of 3 or more substrates).

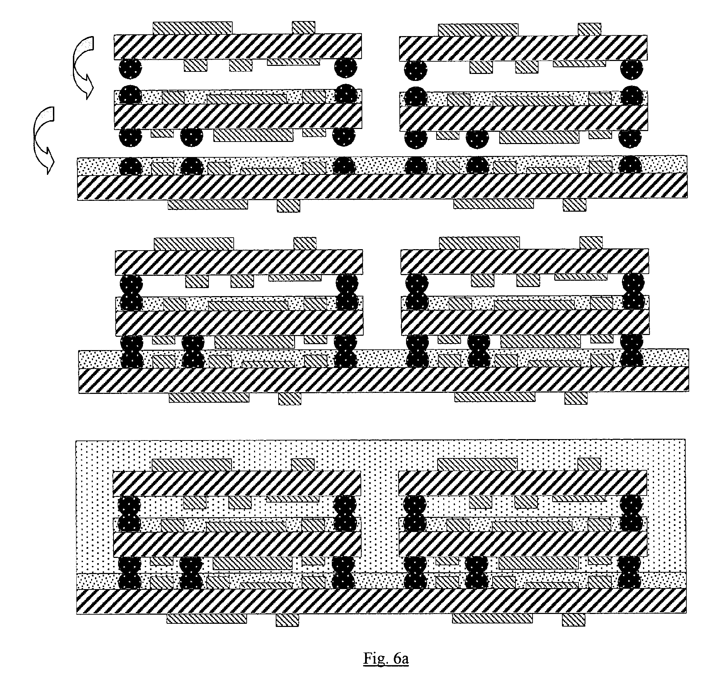

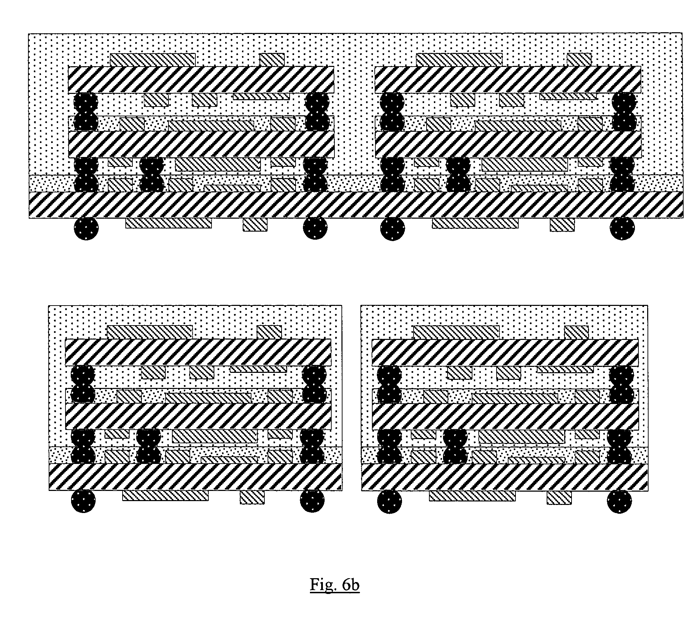

Fig. 6a and 6b: principle of the SiP substrate stacking: using wafer or substrate as a basis (case of 3 or more substrates).

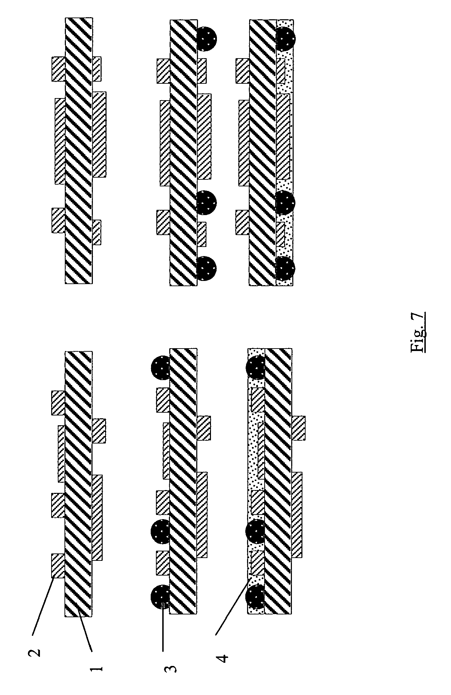

In Fig. 7 to Fig. 9, further embodiments according to the present invention are illustrated, which are similar to the embodiments of Fig. 1 to Fig. 6, but wherein both solder balls which are to be joined are both partially embedded in a non-conductive material as described in detail in the description.

Fig. 7: alternative preparation of the SiP substrate (case of 2 substrates).

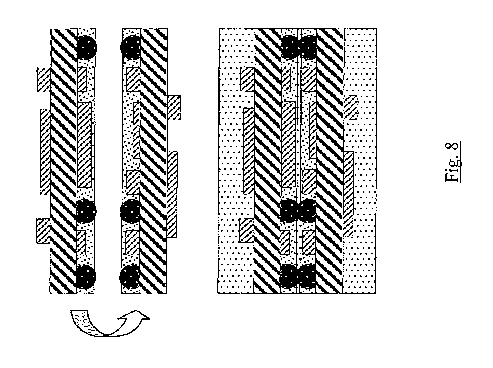

Fig. 8: principle of the SiP substrate stacking (alternative case of 2 substrates).

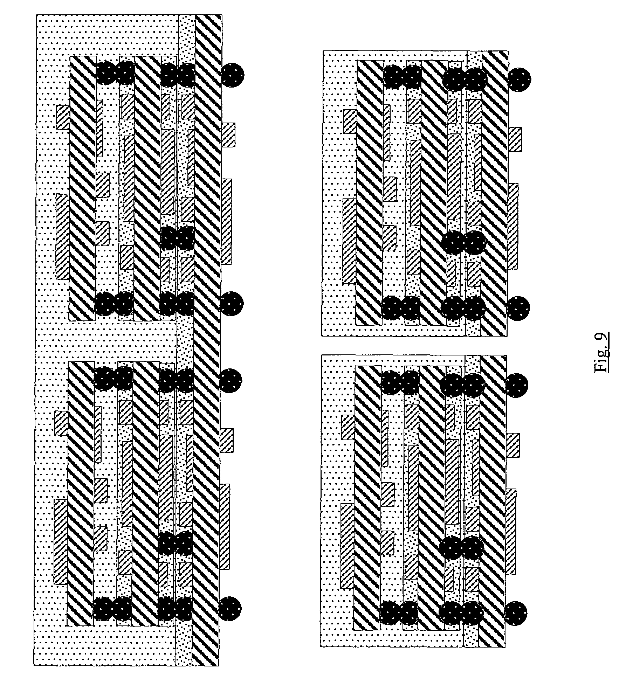

Fig. 9: principle of the SiP substrate stacking : using wafer or substrate-level.
Base wafer (case of 3 or more substrates, alternative)

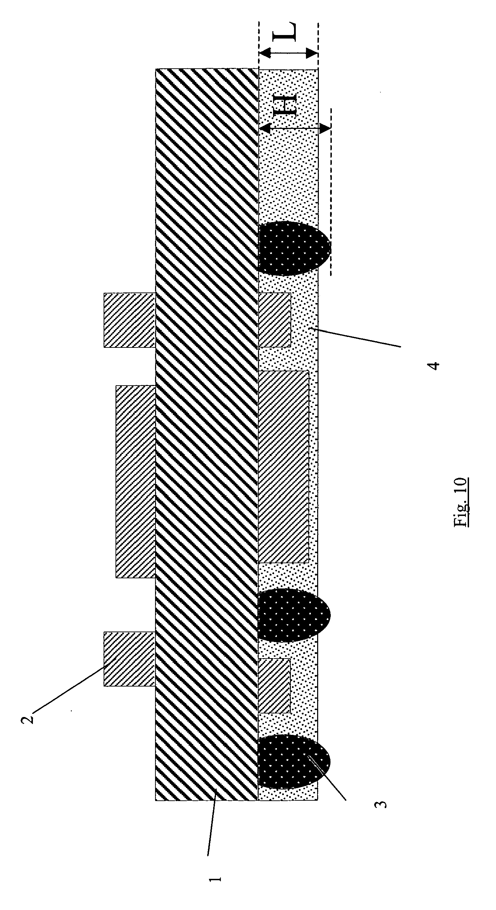

In Fig. 10 a generic representation is given of a solder ball or structure on a first main surface of an element and the height parameter is indicated.

Fig. 11 to 14 illustrate embodiments of the present invention. Fig. 13b is a top view of Fig. 13a.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes. It is to be understood that the terms so used are interchangeable under appropriate circumstances and that the embodiments of the invention described herein are capable of operation in other orientations than described or illustrated herein. The same reference signs in different figures refer to similar elements.

In Fig. 1 the preparation SiP devices for 3D stacking is illustrated, according to embodiments of the present invention. Sequence A is directed to a bottom substrate and sequence B to a top substrate.
Components 2 are mounted on the elements 1, eg substrates or wafers. The component can be any type of surface mount component known to a person of ordinary skill in the art. Such component typically extends outwards of a main surface of the element e.g. substrate. In Fig. 10 the parameters "H"; height and "L"; level are illustrated generically.

Next, solder balls 3 are attached to the top of the bottom substrate and the bottom of the top substrate, using standard BGA and CSP solder ball mounting techniques. In preferred embodiments pre-form solder balls are used, placed on the substrate by a collective technique (e.g. stencil printing) and attached to the substrates by reflow soldering.

The attachment may actually be performed simultaneously with the deposition of some of the surface mount components 2 in the prior step. In other embodiments the solder balls can be individually picked and placed with a fine pitch SMT (surface mount technology) placement machine.

In a next step, the solder balls and surface mounted components on the bottom wafer are encapsulated with a polymer layer 4. The solder balls should however not be completely covered by this layer.

Possible methods are the dispensing of a liquid epoxy 'glob-top' or 'under-fill' type compound that automatically levels and fills all gaps between and below components. Also transfer molding of plastic encapsulation material can be used.

In case the solder balls are covered by a layer thicker than the solder balls, a back grinding step can be used to reduce the thickness of the polymer layer and expose the top surface of the solder balls (a segment of the top of the solder ball will be removed, leaving a approximately flat, typically circular solder area).

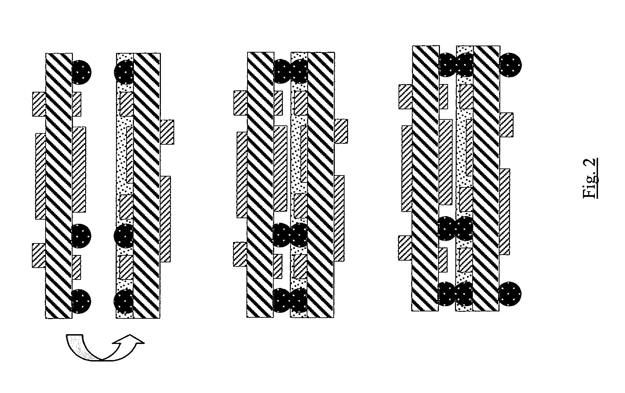

In Fig. 2 the principle of stacking of 2 SIP devices according to embodiments of the present invention are illustrated.

The top substrate SiP is mounted to the base substrate and attached using solder reflow. The distance between the substrates is maintained as the bottom solder ball is not able to collapse during soldering. From a certain viewpoint, the bottom solder balls act as a regular contact pads for the top SiP solder balls.

After reflow, solder balls can be applied to the second main surface of the bottom substrate to finalize the 3D-SiP assembly. In other embodiments, the solder balls on the second main surface of the bottom substrate can be already present before the reflow step.

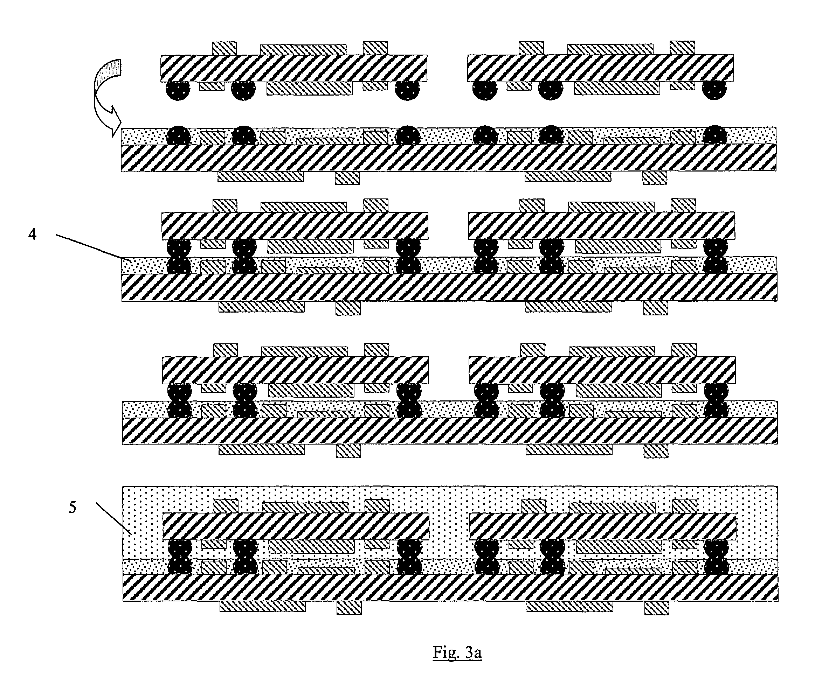

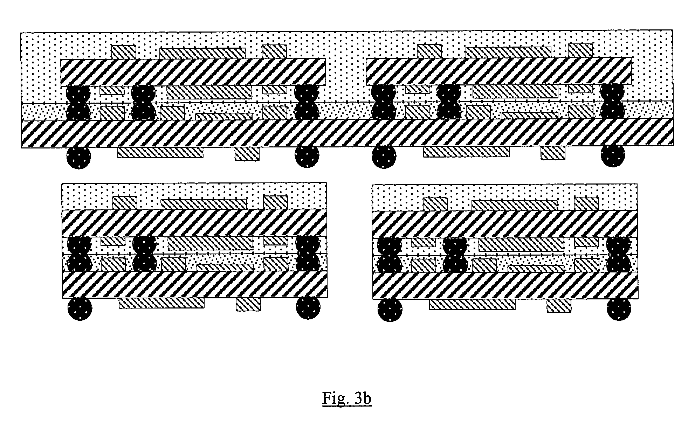

This step of Fig. 2 may be performed with large substrates with arrays of SIP devices or with singulated and tested SiP substrates, or with singulated and tested SiP devices mounted on tested SiP substrates as shown in Fig. 3a and Fig. 3b. Such testing performed on the devices and substrates can be testing the functioning, the performance, the reliability etc of the devices and substrates respectively.

In Fig. 3, embodiments according to the present invention are illustrated, wherein tested SIP devices are stacked on SIP substrates (case of 2 SIP devices).

This flow is similar as the one of fig. 2, but here tested known-good SIP are placed on tested known-good SIP sides of the bottom wafer (with 'known-good' is meant "tested with a positive result", and thus properly usable). Defective sites on the bottom substrate can be and are preferably left empty.

In addition, after mounting the devices, an underfill/overmold operation can be performed, encapsulating all structures by a layer 5, see figure 3a and Fig. 6. Standard transfer molding is a preferred option for this process, but also possible is the use of liquid epoxy encapsulants as used for 'glob-top' or 'under-fill' applications, as well as suitable options known to a person of ordinary skill.

Solder balls can be applied to the second main surface of the bottom substrate after this molding step (figure 3b), or before. After this step, dicing the substrate to obtain fully encapsulated 3D-SIP devices can be performed.

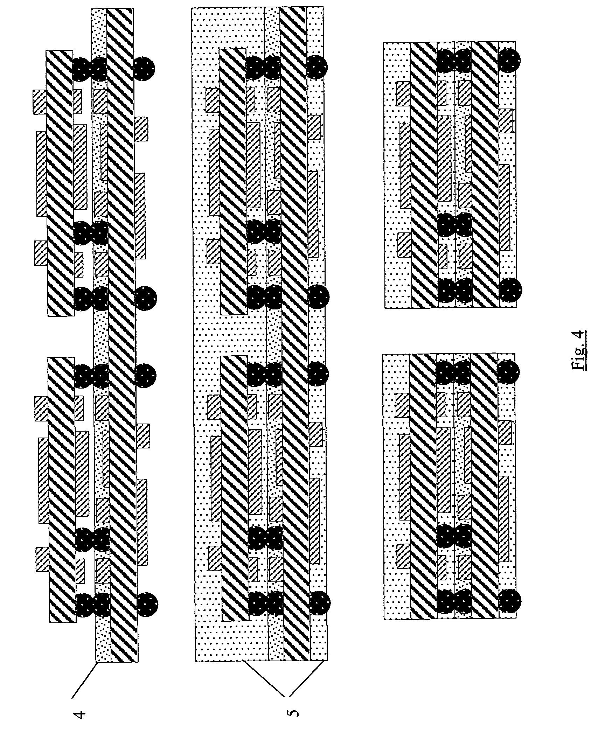

In fig. 4 further embodiments according to the present invention are illustrated. Here, solder balls are provided to the second main surface of the bottom substrate before the moulding step,

Moulding is performed on both sides of the substrate (see layers 5 in figure 4), however, leaving the tips of the bottom solder balls partially free. This module can be used as land-grid array type package, or a second solder ball can be applied on the bottom for improved thermo-mechanical reliability after assembly to a motherboard.

In Fig. 5 and 6 other embodiments according to the present invention are depicted. The preparation and stacking of SiP devices for 3D stacking in the case of 3 or more samples is shown.

These embodiments are similar to those of fig. 1 to Fig. 4, regarding the preparation of the bottom (sequence A) and top (sequence C) substrates. However, the substrate or substrates in the middle (sequence B) are receiving solder balls on both sides.

In certain embodiments a reflow step can be applied at each bonding process between 2 elements. In other embodiments the same solder reflow step can be applied for bonding all elements in a stack. In certain embodiments, N reflow steps are performed for bonding M elements, with N < M-1, for M > 2.

In Fig. 7 to Fig. 9, further embodiments according to the present invention are illustrated, which are similar to the embodiments of Fig. 1 to Fig. 6, but wherein both solder balls respectively attached to a first main surface of a first element and a first main surface of a second element are both embedded laterally up to respectively level L and L', which are below the respective levels H and H' of the top surface of the respective solder balls. (see Fig. 10 where a generic representation is given of a solder ball or structure on a first main surface of an element and the height parameters L and H are indicated).

Such structures can be used in the bonding of 2, 3, or more SIP levels. For each couple of to be joined solder balls at least one, but also both solder balls can be embedded laterally by a non-conductive material. This choice depends on the requirements, typically spacing between 2 SIP level - requirements, of a specific structure.

## Claims

1. A method for bonding elements comprising the steps of
- producing on a first main surface of a first element a first solder ball,
- producing on a first main surface of a second element a second solder ball,
- providing contact between said first solder ball and said second solder ball,
- bonding said first element and said second element by applying a reflow step whereby said solder balls melt and form a joined solder ball structure
wherein, prior to the bonding step, said first solder ball is laterally embedded in a non conductive material, such that the upper part of said first solder ball is not covered by said non-conductive material

2. Method according to claim 1, wherein said non conductive material is laterally embedding said first solder ball up to a level parallel to the first main surface and which does not extend above said first solder ball.

3. Method according to claim 1 or 2, further comprising a step of applying an underfill material after the bonding step between said first main surface of said second element and said first main surface of said first element.

4. Method according to claim 1 or 2, wherein said second solder ball is laterally embedded in a non conductive material, such that the upper part of said first solder ball is not covered by said non-conductive material.

5. Method according to claim 4, wherein said non conductive material is laterally embedding said second solder ball up to a level parallel to the first main surface and which does not extend above said second solder ball.

6. method according to claim 1 to 5, wherein said non conductive material further comprises exclusion areas or recesses.

7. Method according to any one of claims 1 to 6, wherein said first main surface of said first element and/or said first main surface of said second element comprise components or structures, and whereby said first and said second solder balls are such that the height of said components and/or structures is smaller then the height of said first solder ball and said second solder ball respectively.

8. Method according to any one of claims 1 to 6, wherein said first main surface of said first element and/or said first main surface of said second element comprise components or structures which have a topology that extends outwards from the respective main surfaces, and whereby said first and said second solder balls are such that the height of at least one of said components and/or structures on the first main surface of the first element and/or the first main surface of the second element is smaller then the height of said joined solder ball structure but larger than the solder balls on the corresponding main surface.

9. Method according to any one of claims 1 to 8, further comprising a step of applying an underfill/overmold operation, which fills up the remaining gaps between said elements.

10. Method for producing stacked structures, wherein the method according to any one of claims 1 to 9 is applied an integer number of times, by repetitively bonding a main surface of an element, bonded before by a method according to any one of claims 1 to 9, to a main surface of a further element.

11. Method according to claim 10, wherein a step of applying an underfill/overmold operation is applied only once for the whole stacked structure.

12. Method according to any one of claims 1 to 11, wherein said elements are substrates, chips or dies.

13. A device comprising at least 2 elements, said elements being bonded by a bonding structure located between a first main surface of a first element and a first main surface of a second element, wherein said bonding structure comprises a solder structure which is essentially a stack of a lower and an upper solder ball, which are forming a single structure.

14. A device according to claim 13, wherein said solder structure is essentially 8-shaped.

15. A device according to claim 13 or 14, wherein said lower or/and said upper solder ball(s) is/are laterally embedded in a non conductive material up to an embedding level which is lower then the height of the top surface of said respective solder balls.

16. A device according to claim 15, wherein the first main surface of at least one of said elements comprises at least one component which extends outwards from said main surface of the corresponding element, and whereby the respective embedding levels are further such that said component(s) are completely covered by said non conductive material.

17. A device according to any one of claims 13 to 16, wherein said bonding structure further comprises a layer of underfill/overmold material in between said main surfaces of said elements.

18. A device according to claim 17, wherein said layer of underfill/overmould material is located between a main surface of one element and an embedding layer or between 2 embedding layers.
